# EUROPÄISCHE PATENTSCHRIFT

(11) **EP 0 566 585 B1**
(45) Veröffentlichungstag und Bekanntmachung des Hinweises auf die Patenterteilung: **29.03.1995**
(21) Anmeldenummer: 92900276.4
(22) Anmeldetag: 10.12.1991
(51) Int. Cl.: G11C 11/22, G11C 19/00

(54) **SPEICHERZELLENANORDNUNG UND VERFAHREN ZU DEREN BETRIEB**
STORAGE CELL ARRANGEMENT AND PROCESS FOR OPERATING IT
SYSTEME DE CELLULES DE MEMOIRE ET PROCEDE DE FONCTIONNEMENT

(30) Priorität: 09.01.1991 DE 4100465
(43) Veröffentlichungstag der Anmeldung: 27.10.1993
(73) Patentinhaber: SIEMENS AKTIENGESELLSCHAFT, 80333 München (DE)
(72) Erfinder: KRAUTSCHNEIDER, Wolfgang Dr., D-8012 Ottobrunn (DE); WERSING, Wolfram Dipl. Phys., D-8011 Kirchheim (DE)
(86) Internationale Anmeldenummer: DE9100957
(87) Internationale Veröffentlichungsnummer: WO9212518

(56) Entgegenhaltungen:
- EP-A- 0 130 614
- EP-B- 0 099 473
- DE-A- 3 212 945

## Beschreibung

Speicherzellen mit Halbleiterbauelementen, die als dynamische oder statische Speicher betrieben werden, verlieren im allgemeinen die eingeschriebene Information nach Abschalten der Versorgungsspannung. Bei einem spontan auftretenden Spannungsausfall werden in diesen Speichern alle eingespeicherten Daten gelöscht.

Bei Speicherzellenanordnungen, die aus dynamischen Eintransistorzellen aufgebaut sind, ergibt sich zudem der Nachteil, daß zum Ausgleich von durch Leckströme abfließender Ladung in regelmäßigem Zeittakt ein Refresh durchgeführt werden muß. Dadurch werden Leistungsverbrauch und Schaltungsaufwand erhöht.

Des weiteren sind dynamische Speicher gegen Alphastrahlung empfindlich. Dadurch werden Fehlerbits hervorgerufen.

Es ist bekannt (s. z. B. S. M. Sze, Semiconductor Devices, John Wiley & Sons 1985, S. 490), zur dauerhaften Speicherung sogenannte elektrisch programmierbare Speicher (EPROM) oder elektrisch programmier- und löschbare Speicher (EEPROM) zu verwenden. In diesen nichtflüchtigen Speichern bleibt die Speicherung bei Abschalten der Spannungsversorgung erhalten. In diesen Speichern wird die Information mit Hilfe der Aufladung eines floatenden Gates durch Injektion heißer Ladungsträger bzw. Fowler-Nordheim Tunnelstrom oder durch Aufladen von Haftstellen an dielektrischen Grenzschichten (MNOS-Transistoren) gespeichert. Das floatende Gate bzw. die Haftstellen sind dabei von einem hochwertigen Isolator umgeben, so daß es praktisch zu keinem Ladungsabfluß kommt.

Ein Nachteil dieser Speicher liegt darin, daß der Schreibvorgang mit Zeitkonstanten im Millisekundenbereich verläuft, d. h. relativ langsam ist. Ein weiterer Nachteil besteht darin, daß der hochwertige Isolator nach etwa 10³ bis 10⁶ Schreibzyklen ermüdet. Danach läßt sich dann keine dauerhafte Ladungsspeicherung mehr durchführen.

Der Erfindung liegt das Problem zugrunde, eine Speicherzellenanordnung und ein Verfahren zu deren Betrieb anzugeben, in der bei Ausfall der Versorgungsspannung die eingeschriebene Information erhalten bleibt und in der der Schreibvorgang schneller als in den bekannten Anordnungen ist.

Das Problem wird erfindungsgemäß gelöst mit einer Speicherzellenanordnung und mit Verfahren, wie sie in den Ansprüchen 1, 14 und 15 definiert sind.

Durch die Verwendung einer ferroelektrischen Schicht als Gatedielektrikum vermeidet die erfindungsgemäße Speicherzellenanordnung die geschilderten Nachteile des Standes der Technik.

Ferroelektrische Materialien, wie z. B. Bleizirkonattitanat, lassen sich durch Anlegen eines elektrischen Feldes, das größer als eine materialspezifische Sättungsfeldstärke ist, remanent polarisieren. Durch Umkehren der Richtung des elektrischen Feldes läßt sich das Vorzeichen der remanenten Polarisation verändern. Ein Feldeffekttransistor, der als Gatedielektrikum eine ferroelektrische Schicht enthält, weist in Abhängigkeit von dem Vorzeichen der Polarisation der ferroelektrischen Schicht zwei unterschiedliche Schwellenspannungen auf, bei denen Stromfluß einsetzt.

Diese Eigenschaft wird in der erfindungsgemäßen Speicherzellenanordnung zum Aufbau einer Speicherzelle mit einem ferroelektrischen Transistor ausgenutzt. Es werden den beiden Schwellenspannungen die logischen Zustände "0" und "1" zugeordnet.

Da der Polarisationszustand der ferroelektrischen Schicht auch ohne äußeres Feld erhalten bleibt, tritt nach Abschalten der Versorgungsspannung kein Informationsverlust auf. Es ist auch bei der erfindungsgemäßen Speicherzellenanordnung kein Refresh erforderlich, und die Speicherzellen sind unempfindlich gegen Alphastrahlung.

In der erfindungsgemäßen Speicherzellenanordnung besteht eine komplette Speicherzelle nur aus dem Feldeffekttransistor mit der ferroelektrischen Schicht als Gatedielektrikum. Der Feldeffekttransistor wird dabei sowohl zur Informationsspeicherung als auch beim Auslesen der Speicherzellenanordnung zur Zellauswahl benutzt. Voraussetzung für die Verwendung des Feldeffekttransistors zur Zellauswahl ist, daß beide Schwellenspannungen dasselbe Vorzeichen haben, d. h. wenn der Feldeffekttransistor ein n-Kanal-Transistor ist, daß beide Schwellenspannungen positiv sind und wenn der Feldeffekttransistor ein p-Kanal-Transistor ist, daß beide Schwellenspannungen negativ sind. Die beiden Schwellenspannungen des Feldeffektransistors lassen sich so einstellen, daß sie beide dasselbe Vorzeichen haben. Durch höhere Substratdotierung wird der Betrag der Schwellenspannung vergrößert, während eine geringere Dicke des Gatedielektrikums den Betrag der Schwellenspannung reduziert. Des weiteren läßt sich der Betrag der Schwellenspannung dadurch erhöhen, daß die Austrittsarbeitsdifferenz zwischen der Gateelektrode und dem Halbleitersubstrat verändert wird. Dies erfolgt z. B. dadurch, daß eine Gateelektrode aus Polysilizium verwendet wird, die vom entgegengesetzten Leitfähigkeitstyp wie Source- und Drain-Gebiet dotiert ist. Diese Maßnahmen zur Einstellung der Schwellenspannungen des Feldeffekttransistors sind unabhängig von der Wahl des Materials für die ferroelektrische Schicht.

Zum Auslesen der in einer ausgewählten Speicherzelle eingeschriebenen Information wird an eine Wortleitung, die mit der Gateelektrode der ausgewählten Speicherzelle verbunden ist, eine Spannung angelegt. Die Spannung liegt dem Betrag nach zwischen den beiden Werten der Beträge der Schwellenspannungen, so daß beim Anliegen dieser Spannung der Feldeffekttransistor je nach Polarisationszustand der ferroelektrischen Schicht sperrt oder leitet. Wenn die ferroelektrische Schicht so polarisiert ist, daß der Betrag der Schwellenspannung des Feldeffekttransistors den höheren Wert beträgt, setzt kein Stromfluß ein, so daß eine logische "0" ausgelesen wird. Ist jedoch die ferroelektrische Schicht so polarisiert, daß die Schwellenspannung dem Betrag nach den kleineren Wert einnimmt, leitet der Transistor, was einer eingespeicherten "1" zugeordnet wird.

Zum Einschreiben von Information in eine ausgewählte Speicherzelle muß zwischen deren Gateelektrode und das Substrat ein Feld angelegt werden, das die Sättigungsfeldstärke der ferroelektrischen Schicht überschreitet. Die ferroelektrische Schicht richtet sich dann in ihrer Polarisationsrichtung nach dem Feld aus, wodurch die Schwellenspannung des Speichertransistors eingestellt wird.

Damit die Schwellenspannung des Feldeffekttransistors, der z. B. ein n-Kanal-Transistor ist, den niedrigeren der beiden möglichen Werte annimmt, muß durch eine ausreichend hohe Spannung zwischen Gatelektrode und Substrat das erforderliche Polarisationsfeld erzeugt werden. Dazu wird an über eine Wortleitung an die Gateelektrode eine positive Spannung angelegt, die dem Betrag nach größer ist als die zur Umpolarisation der ferroelektrischen Schicht erforderliche Sättigungsfeldstärke, während Sourcegebiet, Draingebiet und Substrat auf Nullpotential gelegt sind.

Um zu verhindern, daß es bei nicht angewählten Speicherzellen der Speicherzellenanordnung, deren Gatelektroden mit der angesteuerten Wortleitung verbunden sind, ebenfalls zu einer Umpolarisierung der ferroelektrischen Schicht kommt, muß das elektrische Feld über der ferroelektrischen Schicht dieser Speicherzellen reduziert werden. Dies wird z. B. dadurch erreicht, daß das am Sourcegebiet und am Draingebiet anliegende Potential entsprechend angehoben wird, z. B. auf den halben wert, der an der Wortleitung anliegt. Da die an der Wortleitung anliegende Spannung weit oberhalb der Schwellenspannung liegt, ist die Halbleiteroberfläche unter dem Gatedielektrikum invertiert. Die Feldstärke über der ferroelektrischen Schicht wird daher durch das Kanalpotential, das über die Spannung des Draingebiets und des Sourcegebiets festgelegt wird, auf einen Wert eingestellt, bei dem noch keine Umpolarisation der ferroelektrischen Schicht auftritt.

Eine andere Möglichkeit zur Reduktion der Feldstärke über der ferroelektrischen Schicht nicht angewählter Speicherzellen besteht darin, in diesen Speicherzellen unterhalb der ferroelektrischen Schicht am Substrat individuell eine Spannung anzulegen, die dem halben Wert der an die Wortleitung angelegten Spannung entspricht. Dadurch wird die Feldstärke über der ferroelektrischen Schicht auf einen Wert begrenzt, der noch nicht zur Umpolarisation der ferroelektrischen Schicht führt. Dazu werden in der erfindungsgemäßen Speicherzellenanordnung Isolationsbereiche vorgesehen, die an derselben Wortleitung liegende Feldeffekttransistoren im Substrat voneinander isolieren. Als Isolationsbereiche sind z. B. BOX-Isolationen geeignet. Unterhalb jedes Feldeffekttransistors sind im Substrat eine erste dotierte Schicht, die wie das Substrat vom ersten Leitfähigkeitstyp dotiert ist und eine zweite dotierte Schicht, die wie die Source- und Drain-Gebiete vom zweiten Leitfähigkeitstyp dotiert ist, vorgesehen. Die erste dotierte Schicht und die zweite dotierte Schicht sind dabei seitlich von den den jeweiligen Feldeffekttransistor isolierenden Isolationsbereichen begrenzt. Die erste dotierte Schicht stellt dabei ein "individuelles Substrat" dar, das durch pn-Übergänge vom allgemeinen Substrat isoliert ist. Über die erste dotierte Schicht wird in den nichtausgewählten Speicherzellen das Potential zur Reduktion der Feldstärke über der ferroelektrischen Schicht angelegt.

Gemäß einer Ausführungsform der Erfindung ist unter der zweiten dotierten Schicht im Substrat eine dritte dotierte Schicht, die vom ersten Leitfähigkeitstyp dotiert ist und unter der dritten dotierten Schicht eine vierte dotierte Schicht, die vom zweiten Leitfähigkeitstyp dotiert ist, angeordnet. Die dritte dotierte Schicht und die vierte dotierte Schicht sind dabei ebenfalls seitlich von dem den jeweiligen Feldeffekttransistor isolierenden Isolationsbereich begrenzt. Die Dotierstoffkonzentrationen der dotierten Schichten werden dabei so eingestellt, daß die aus der ersten dotierten Schicht und der zweiten dotierten Schicht sowie die aus der zweiten dotierten Schicht und der dritten dotierten Schicht gebildeten Zenerdioden Durchbruchsspannungen haben, die in der Nähe der für die Umpolung der ferroelektrischen Schicht erforderlichen Spannung liegen. Wird in einer solchen Speicherzelle zwischen die dritte dotierte Schicht und die Gateelektrode eine Spannung angelegt, die die Sättigungsfeldstärke zur Umpolarisation der ferroelektrischen Schicht übersteigt, wird die Durchbruchsspannung der Zenerdioden überschritten, so daß die angelegte Spannung fast vollständig über der ferroelektrischen Schicht abfällt. Wird andererseits ein geringerer Spannungspegel an die dritte dotierte Schicht angelegt, z. B. die Hälfte der Sättigungsfeldstärke, so wird die Durchbruchsspannung der Zenerdioden nicht erreicht. Über der ferroelektrischen Schicht bildet sich dann nur eine geringe Spannung aus, deren Wert weit unterhalb des zwischen der Gateelektrode und der dritten dotierten Schicht anliegenden Spannungswertes liegt. In dieser Ausführungsform wird ein partielles Umpolarisieren der ferroelektrischen Schicht vermieden, daß bei Spannungen über der ferroelektrischen Schicht auftritt, die nur wenig unter der Polarisationsfeldstärke liegen.

Damit die ferroelektrische Schicht so polarisiert wird, daß die Schwellenspannung des Feldeffekttransistors den größeren der beiden möglichen Werte annimmt, werden Source- und DrainGebiet auf eine positve Spannung gelegt, die der Sättigungsfeldstärke entspricht, während die Gateelektrode der betreffenden Zelle mit Nullpotential verbunden ist. Die ferroelektrische Schicht wird in der ausgewählten Speicherzelle dann im Bereich von Source- und Drain-Gebiet umpolarisiert. Das Potential der Wortleitungen der übrigen Speicherzellen, die an denselben Drain- und Bit-Leitungen liegen, wird auf einen positiven Spannungswert angehoben, der geringer als die Sättigungsfeldstärke ist. Dadurch wird in diesen Speicherzellen die zur Umpolarisation erforderliche Feldstärke nicht erreicht.

Um die ferroelektrische Schicht im gesamten Gatebereich umpolarisieren zu können, ist es vorteilhaft, unter dem Gatedielektrikum die erste dotierte Schicht vom ersten Leitfähigkeitstyp und darunter die zweite dotierte Schicht vom zweiten Leitfähigkeitstyp vorzusehen und an derselben Wortleitung liegende Feldeffekttransistoren durch Isolationsbereiche zu isolieren. Es wird dann auch die erste dotierte Schicht der ausgewählten Speicherzelle mit der der positiven Spannung entsprechenden Sättigungsfeldstärke verbunden.

In der Ausführungsform der Speicherzellenanordnung, in der die dritte dotierte Schicht und die vierte dotierte Schicht vorgesehen sind, wird die Wortleitung der ausgewählten Speicherzelle auf Nullpotential gelegt, während die dritte dotierte Schicht auf eine positive Spannung entsprechend der Sättigungsfeldstärke gelegt wird. Dadurch wird die Durchbruchsspannung der Zenerdioden überschritten, so daß die angelegte Spannung fast vollständig über der ferroelektrischen Schicht abfällt und die ferroelektrische Schicht umpolarisiert wird. Die Wortleitungen der übrigen nichtausgewählten Speicherzellen werden auf eine positive Spannung, die z. B. die Hälfte der Sättigungsfeldstärke beträgt, gelegt. Dadurch wird in diesen Speicherzellen die Durchbruchsspannung der Zenerdioden nicht erreicht. Die Feldstärke, die an der ferroelektrischen Schicht anliegt, ist dann so niedrig, daß deren Polarisationszustand unverändert bleibt.

Um bei Verwendung eines Siliziumeinkristalls als Substrat gute Kristalloberflächen mit niedrigen Phasengrenzzustandsdichten im Kanalbereich der Feldeffekttransistoren herzustellen, ist es vorteilhaft, das Gatedielektrikum als Mehrschichtdielektrikum auszubilden. Das Gatedielektrikum besteht aus einer dünnen ersten SiO₂-Schicht auf dem Siliziumsubstrat, der ferroelektrischen Schicht und einer zweiten SiO₂-Schicht, auf die die Gateelektrode aus z. B. polykristallinem Silizium aufgebracht wird. In dieser Ausführungsform werden stabile Schwellenspannungen erzielt.

Um die Schwellenspannung der Feldeffekttransistoren wirksam durch die Umpolarisierung der ferroelektrischen Schicht beeinflussen zu können, ist es vorteilhaft, die Dicken der SiO₂-Schichten und der ferroelektrischen Schicht so zu wählen, daß das Verhältnis der relativen Dielektrizitätskonstanten von ferroelektrischer Schicht und SiO₂-Schicht vergleichbar mit dem Schichtdickenverhältnis ist.

Es liegt im Rahmen der Erfindung, die Feldeffekttransistoren an gegenüberliegenden Seitenwänden eines Längsgrabens im Substrat anzuordnen. Dadurch werden sehr kleinen Zellflächen erzielt. Im folgenden wird die Erfindung anhand von Ausführungsbeispielen und der Figuren näher erläutert.
- Fig. 1: zeigt eine Speicherzellenanordnung mit Feldeffekttransistoren, in deren Gatedielektrikum eine ferroelektrische Schicht enthalten ist.
- Fig. 2: zeigt eine Aufsicht auf die in Fig. 1 dargestellte Speicherzellenanordnung.
- Fig. 3: zeigt einen Feldeffekttransistor der erfindungsgemäßen Speicherzellenanordnung mit einem Mehrschichtdielektrikum.
- Fig. 4: zeigt einen Ausschnitt aus einer Speicherzellenanordnung, in der an die einzelnen Speicherzellen individuelle Substratspannungen angelegt werden.
- Fig. 5: zeigt eine Speicherzellenanordnung mit im Substrat integrierten Zenerdioden.
- Fig. 6: zeigt ein Ersatzschaltbild der in Fig. 5 dargestellten Speicherzellen.
- Fig. 7: zeigt eine Speicherzellenanordnung mit in einem Längsgraben angeordneten Speicherzellen.
- Fig. 8: zeigt den mit VIII-VIII in Fig. 7 bezeichneten Schnitt.
- Fig. 9: zeigt ein Ersatzschaltbild der in Fig. 7 dargestellten Speicherzellenanordnung.
- Fig. 10: zeigt eine Speicherzellenanordnung mit in einem Graben angeordneten Speicherzellen, in der an die einzelnen Speicherzellen individuelle Substratspannungen angelegt werden.

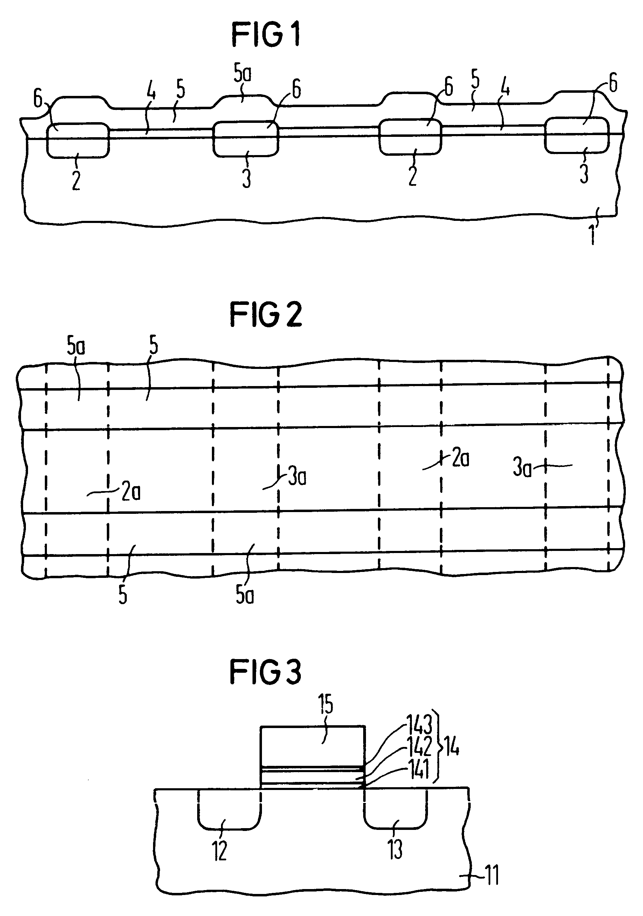

In einem Substrat 1, das z. B. aus einkristallinem Silizium besteht und z. B. p-dotiert ist, sind als Speicherzellen Feldeffekttransistoren enthalten (s. Fig. 1). Die Feldeffekttransistoren enthalten jeweils ein Source-Gebiet 2, das z. B n⁺-dotiert ist und ein Drain-Gebiet 3, das ebenfalls z. B. n⁺-dotiert ist. Auf der Oberfläche des Substrat 1 ist zwischen Source-Gebiet 2 und Drain-Gebiet 3 jeweils ein Gate-Dielektrikum 4 angeordnet. Das Gate-Dielektrikum 4 enthält eine ferroelektrische Schicht, z. B. aus Bleizirkonattitanat. Oberhalb des Gatedielektrikums 4 ist eine Gateelektrode 5 angeordnet, die z. B. aus polykristallinem Silizium besteht. Jeder Feldeffekttransistor hat abhängig vom Polarisationszustand der ferroelektrischen Schicht zwei unterschiedliche, positive Schwellenspannungen, die in der Speicherzellenanordnung zwei unterschiedlichen logischen Zuständen zugeordnet werden. Zur Umpolarisation der ferroelektrischen Schicht, und damit zum Umschalten von einem Wert der Schwellenspannung auf den anderen, wird zwischen die Gateelektrode 5 und das Substrat 1 ein elektrisches Feld angelegt, das größer ist als das zur Umpolarisation der ferroelektrischen Schicht notwendige Sättigungsfeld. Je nach Richtung des elektrischen Feldes wird dabei die eine oder andere Schwellenspannung eingestellt.

Die Feldeffekttransistoren sind im Substrat 1 matrixartig in Zeilen und Spalten angeordnet. Dabei sind die Gatelektroden 5 jeder Spalte jeweils mit einer Wortleitung 5a verbunden (s. Fig. 2). Die Wortleitung 5a und die Gateelektroden 5 sind z. B. als durchgehende polykristalline Siliziumschicht ausgebildet. In dem Substrat sind die Source-Gebiete 2 der jeweils in einer Zeile angeordneten Feldeffekttransistoren über eine Bitleitung 2a miteinander verbunden. Die Drain-Gebiete 3 der Feldeffekttransistoren, die in einer Zeile im Substrat 1 angeordnet sind, sind über eine Drainleitung 3a miteinander verbunden. Die Bitleitung 2a und die Drainleitung 3a sind z. B. als durchgehende, die Source-Gebiete 2 bzw. Drain-Gebiete 3 enthaltende Diffusionsgebiete im Substrat 1 ausgebildet. Die Source-Gebiete 2 und die Drain-Gebiete 3 sind an Kreuzungspunkten mit den Wortleitungen 5a jeweils durch Isolationen 6 von den Wortleitungen 5a isoliert (s. Fig. 1).

In einem Substrat 11 aus z. B. p-dotiertem einkristallinem Silizium sind ein Source-Gebiet 12 und ein Drain-Gebiet 13 angeordnet (s. Fig. 3). An der Oberfläche des Substrats 11 ist zwischen dem Source-Gebiet 12 und dem Drain-Gebiet 13 ein Gatedielekrikum 14 angeordnet. Das Gatedielektrikum 14 ist zusammengesetzt aus einer ersten SiO₂-Schicht 141, einer ferroelektrischen Schicht 142 und einer zweiten SiO₂-Schicht 143. Die ferroelektrische Schicht 142 besteht z. B. aus Bleizirkonattitanat. Das Verhältnis der Dicke der SiO₂-Schichten und der ferroelektrischen Schicht 142 ist dabei ungefähr gleich dem Verhältnis der Dielektrizitätskonstanten von SiO₂ und dem Ferroelektrikum, bezogen auf die Polarisation des Ferroelektrikums. Die Dicken betragen z. B. für die ferroelektrische Schicht 142 100 nm und für die SiO₂-Schichten 141, 143 jeweils 5 nm. Auf dem Gatedielektrikum 14 ist eine Gateelektrode 15 angeordnet. Die Gatelektrode 15 besteht z. B. aus polykristallinem Silizium. Durch Verwendung der ersten SiO₂-Schicht 141 auf der Oberfläche des Substrats 11 wird eine gute Kristalloberfläche mit niedrigen Phasengrenzzustandsdichten im Kanalbereich realisiert, die für stabile Schwellenspannungen wichtig ist.

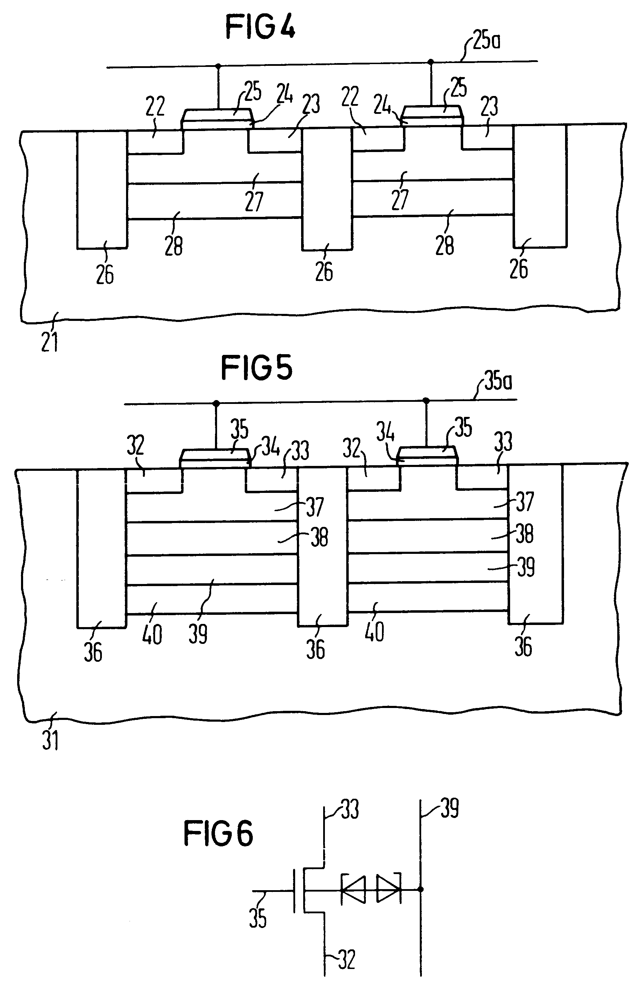

In einem Substrat 21 aus z. B. p-dotiertem, einkristallinem Silizium sind als Speicherzellen Feldeffekttransistoren mit jeweils einem Source-Gebiet 22 und einem Drain-Gebiet 23 angeordnet (s. Fig. 4). Das Source-Gebiet 22 und das Drain-Gebiet 23 sind dabei jeweils n⁺-dotiert. Zwischen dem Source-Gebiet 22 und dem Drain-Gebiet 23 ist an der Oberfläche des Substrats 21 ein Gatedielektrikum 24 angeordnet. Das Gatedielektrikum 24 enthält eine ferroelektrische Schicht z. B. aus Bleizirkonattitanat. Das Gatedielektrikum 24 ist z. B. als Mehrschichtdielektrikum ausgebildet, bestehend aus einer ersten dünnen SiO₂-Schicht, der ferroelektrischen Schicht und einer zweiten, dünnen SiO₂-Schicht. Auf dem Gatedielektrikum 24 ist eine Gateelektrode 25 aus z. B. polykristallinem Silizium angeordnet (s. Fig. 4). Die Feldeffekttransistoren sind im Substrat 21 matrixartig in Zeilen und Spalten angeordnet. Dabei sind die Gatelektroden 25 einer Spalte über eine Wortleitung 25a miteinander verbunden. Die Source-Gebiete 22 und die Drain-Gebiete 23 derjenigen Feldeffekttransistoren, die in einer senkrecht zur Zeichenebene verlaufenden Zeile angeordnet sind, sind jeweils untereinander über eine Bitleitung bzw. eine Drainleitung (in diesem Schnitt nicht sichtbar) miteinander verbunden. Feldeffekttransistoren, deren Gateelektroden mit derselben Wortleitung 25a verbunden sind, sind im Substrat 21 voneinander durch Isolationsbereiche 26 getrennt. Die Isolationsbereiche 26 sind z. B. als BOX-Isolationen oder als mit Isolationsmaterial gefüllte Gräben (Trench) ausgebildet. Im Substrat 21 ist unterhalb von dem Source-Gebiet 22 und dem Drain-Gebiet 23 eine erste dotierte Schicht 27 angeordnet. Die erste dotierte Schicht 27 ist von demselben Leitfähigkeitstyp wie das Substrat 21, z. b. p-dotiert. Die erste dotierte Schicht 27 reicht zwischen dem Source-Gebiet 22 und dem Drain-Gebiet 23 bis an das Gatedielektrikum 24 heran. Seitlich ist die erste dotierte Schicht 27 durch die Isolationsbereiche 26 begrenzt. Unterhalb der ersten dotierten Schicht 27 ist eine zweite dotierte Schicht 28 angeordnet, die vom entgegengesetzten Leitfähigkeitstyp wie die erste dotierte Schicht 27 ist, d. h. die zweite dotierte Schicht 28 ist z. B. n-dotiert. Seitlich wird die zweite dotierte Schicht 28 ebenfalls durch die Isolationsbereiche 26 begrenzt. Über die erste dotierte Schicht 27 ist für jeden Feldeffekttransistor, dessen Catelektrode 25 mit der Wortleitung 25a verbunden ist, eine von den übrigen Feldeffekttransistoren an derselben Wortleitung 25a unabhängige, individuelle Substratspannung anlegbar. Die erste dotierte Schicht 27 hat daher die Wirkung einer Substratleitung. Die erste dotierte Schicht 27 ist durch die pn-Übergänge an den Oberflächen der zweiten dotierten Schicht 28 auch von dem allgemeinen Substrat 21 dielektrisch isoliert.

Zum Einstellen der Schwellenspannung eines vorgegebenen Feldeffekttransistors auf den niedrigeren der beiden möglichen Werte wird an die Gatelektrode 25 über die Wortleitung 25a eine ausreichend hohe, positive Spannung angelegt. Die erste dotierte Schicht 27 wird für den vorgegebenen Feldeffekttransistor auf Nullpotential, für die übrigen an derselben Wortleitung 25a liegenden Feldeffekttransistoren auf einen positiven Spannungswert, z. B. auf die Hälfte der an der Wortleitung 25a anliegenden Spannung eingestellt. Dadurch wird nur in dem vorgegebenen Feldeffekttransistor die Sättigungsfeldstärke zur Umpolarisation der ferroelektrischen Schicht erreicht.

Um die Schwellenspannung des vorgegebenen Feldeffekttransistors auf den höheren der möglichen Werte einzustellen, wird an die Wortleitung 25a des vorgegebenen Feldeffekttransistors Nullpotential gelegt. An das Source-Gebiet 22, das Drain-Gebiet 23 und die erste dotierte Schicht 27 wird eine zur Umpolarisation ausreichend hohe Spannung angelegt. Die Wortleitungen aller an derselben Drain- und Bitleitung liegenden Feldeffekttransistoren werden auf eine positve Spannung gelegt, die z. B. halb so groß wie die an der Wortleitung 25a des ausgewählten Feldeffekttransistors liegende Spannung ist. Dadurch wird wiederum nur an dem ausgewählten Feldeffekttransistor die Sättigungsfeldstärke zur Umpolarisation der ferroelektrischen Schicht erreicht.

In einem Substrat 31, das z. B. aus p-dotiertem, einkristallinem Silizium besteht, sind matrixartig in Spalten und Zeilen als Speicherzellen Feldeffekttransistoren angeordnet (s. Fig. 5). Jeder Feldeffekttransistor enthält ein Source-Gebiet 32 und ein Drain-Gebiet 33, die n⁺-dotiert sind. Zwischen dem Source-Gebiet 32 und dem Drain-Gebiet 33 ist an der Oberfläche des Substrats 31 ein Gatedielektrikum 34 angeordnet. Das Gatedielektrikum 34 enthält eine ferroelektrische Schicht, z. B. aus Bleizirkonattitanat. Das Gatedielekrikum 34 ist z. B. als Mehrschichtdielektrikum mit einer ersten SiO₂-Schicht, der ferroelektrischen Schicht und einer zweiten SiO₂-Schicht ausgebildet. Auf dem Gatedielektrikum 34 ist eine Gateelektrode 35 angeordnet. Die Gateelektroden 35 aller in einer Spalte angeordneten Feldeffekttransistoren sind über eine Wortleitung 35a miteinander verbunden. Die Feldeffekttransistoren, deren Gateelektroden 35 über die Wortleitung 35a miteinander verbunden sind, sind im Substrat 31 seitlich durch Isolationsbereiche 36 voneinander isoliert. Die Isolationsbereiche 36 bestehen z. B. aus BOX-Isolationen oder aus mit Isolationsmaterial gefüllten Gräben (s. Fig. 5).

Die Source-Gebiete 32 aller in einer Zelle (senkrecht zur Zeichenebene) angeordneten Feldeffekttransistoren sind über eine Bitleitung miteinander verbunden. Die Drain-Gebiete 33 der in einer Zeile (senkrecht zur Zeichenebene) angeordneten Feldeffekttransistoren sind über einen Drainleitung miteinander verbunden.

Unterhalb des Source-Gebietes 32 und des Drain-Gebietes 33 ist eine erste dotierte Schicht 37 angeordnet. Die erste dotierte Schicht 37 ist vom gleichen Leitfähigkeitstyp wie das Substrat 31, d. h. z. B. p-dotiert und reicht zwischen dem Source-Gebiet 32 und dem Drain-Gebiet 33 bis an das Gatedielektrikum 34 heran. Die erste dotierte Schicht 37 ist seitlich durch die Isolationsbereiche 36 begrenzt. Unterhalb der ersten dotierten Schicht 37 ist eine zweite dotierte Schicht 38 angeordnet. Die zweite dotierte Schicht 38 ist vom entgegengesetzten Leitfähigkeitstyp wie die erste dotierte Schicht 37, d. h. z. B. n-dotiert. Die zweite dotierte Schicht 38 ist seitlich von den Isolationsbereichen 36 begrenzt. Senkrecht zur Zeichenebene sind die erste dotierte Schicht 37 und die zweite dotierte Schicht 38 durch Isolationen unterbrochen, die jeweils den Bereich jedes Feldeffekttransistors begrenzen. Diese Isolationen sind z. B. als BOX-Isolationen ausgebildet und reichen von der Substratoberfläche bis zur Unterkante der zweiten dotierten Schicht 38.

Unter der zweiten dotierten Schicht 38 ist eine dritte dotierte Schicht 39 angeordnet, die von demselben Leitfähigkeitstyp wie das Substrat 31, d. h. p-dotiert ist. Die dritte dotierte Schicht 39 wird seitlich durch die Isolationsbereiche 36 begrenzt und verläuft senkrecht zur Zeichenebene unterhalb aller in einer Zeile angeordneten Feldeffekttransistoren. Unter der dritten dotierten Schicht 39 ist eine vierte dotierte Schicht 40 angeordnet, die von demselben Leitfähigkeitstyp wie die zweite dotierte Schicht 38, d. h. z. B. n-dotiert ist. Die vierte dotierte Schicht 40 ist seitlich durch die Isolationsbereiche 36 begrenzt und verläuft senkrecht zur Zeichenebene unterhalb aller in einer Zeile angeordneten Feldeffekttransistoren.

Die pn-Übergänge an der Grenzfläche zwischen der ersten dotierten Schicht 37 und der zweiten dotierten Schicht 38 sowie an der Grenzfläche zwischen der zweiten dotierten Schicht 38 und der dritten dotierten Schicht 39 bilden zwei gegenpolig in Reihe geschaltete Zenerdioden.

In dieser Ausführungsform wirkt die dritte dotierte Schicht 39 als Substratleitung, über die an jeden Feldeffekttransistor unabhängig von den an derselben Wortleitung liegenden Feldeffekttransistoren eine individuelle Substratspannung angelegt wird. Die dritte dotierte Schicht 39 ist durch die vierte dotierte Schicht 40 von dem allgemeinen Substrat 31 dielektrisch isoliert.

Die Dotierungen der ersten dotierten Schicht 37, der zweiten dotierten Schicht 38 und der dritten dotierten Schicht 39 werden so eingestellt, daß die beiden Zenerdioden eine Durchbruchsspannung aufweisen, die beim Anlegen des Spannungspegels zur Umpolarisation der ferroelektrischen Schicht überschritten wird. Bei Anlegen des halben Spannungspegels wird die Durchbruchsspannung der Zenerdioden jedoch nicht erreicht. Die Zenerdioden weisen z. B. eine Dotierung im Bereich um ca. 10¹⁰ cm⁻³ auf.

Beim Anlegen einer Spannung zwischen der dritten dotierten Schicht 39 und der Gateelektrode 35 bewirken die Zenerdioden eine kapazitive Spannungsteilung. Der Hauptteil der Spannung fällt über den Zenerdioden ab, da ihre Kapazität klein ist im Vergleich zur Gatekapazität des Speichertransistors. Liegt zwischen der Gateelektrode 35 und der dritten dotierten Schicht 39 eine Spannung an, die geringer ist als die Durchbruchsspannung der Zenerdioden, fällt über der ferroelektrischen Schicht im Gatedielektrikum 34 nur eine geringe Spannung ab, die weiter unterhalb des zur Umpolarisation der ferroelektrischen Schicht notwendigen Wertes ist. Liegt dagegen zwischen der dritten dotierten Schicht 39 und der Gateelektrode 35 eine Spannung an, die größer als die Durchbruchsspannung der Zenerdioden ist, dann fällt die angelegte Spannung fast vollständig über der ferroelektrischen Schicht ab. Da die Durchbruchsspannung der Zenerdioden erfindungsgemäß bei Spannungen erreicht wird, die größer als die Sättigungs feldstärke der ferroelektrischen Schicht sind, reicht die an der ferroelektriscnen Schicht anliegende Spannung dann zur Umpolarisation aus.

Aufgrund des endlichen Sperrwiderstandes der Zenerdioden nähert sich das Substratpotential der Speicherzelle mit einer Zeitkonstanten τ = R_{z} x C_{Zelle} dem Potential der dritten dotierten Schicht 39, wobei R_{z} der Sperrwiderstand der Zenerdioden und C _{Zelle} die Kapazität der Speicherzelle ist. Diese Zeitkonstante muß so gewählt werden, daß sie groß ist im Vergleich zu der Zeitdauer, während der die Spannungspegel zum Einschreiben der Information an der Speicherzelle anliegen. Folgende Werte werden z. B. verwendet: Zeitkonstante 1 »s, Zeitdauer 5 - 10 ns, Spannungspegel 3,3 V.

In Fig. 6 ist ein Ersatzschaltbild für eine Speicherzelle, wie sie anhand von Fig. 5 beschrieben wurde dargestellt. Zwischen die Gateelektrode 35 und die dritte dotierte Schicht 39 sind zwei Zenerdioden gegenpolig in Reihe geschaltet.

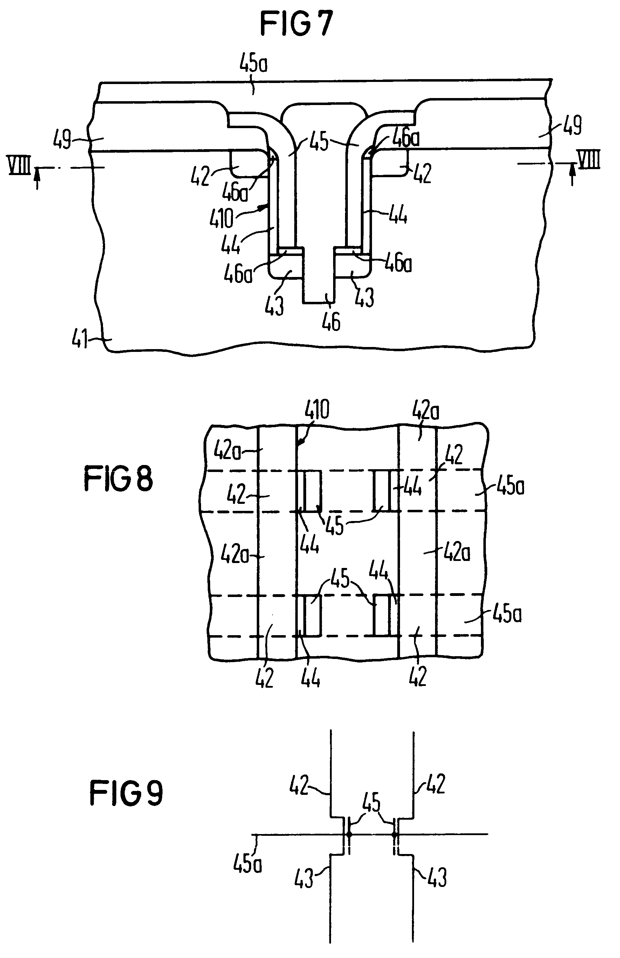

In einem Substrat 41 aus z. B. p-dotiertem, einkristallinem Silizium ist ein Graben 410 vorgesehen (s. Fig. 7). An zwei gegenüberliegenden Flanken des Grabens 410 ist jeweils ein Gatedielektrikum 44 angeordnet. Am Boden des Grabens 410 ist im Substrat 41 an das Gatedielektrikum 44 angrenzend ein n⁺-dotiertes Draingebiet 43 angeordnet. An der Oberfläche des Substrats 41 ist seitlich an das Gatedielektrikum 44 ein n⁺-dotiertes Source-Gebiet 42 angeordnet. Außerhalb des Grabens 410 ist die Oberfläche des Substrats 41 mit einer Isolationsschicht 49 versehen. Auf dem Gatedielektrikum 44 ist eine Gatelektrode 45 aus z. B. Polysilizium so angeordnet, daß sie vom Drain-Gebiet 43 und vom Source-Gebiet 42 durch Isolationen 46a isoliert ist und daß sie seitlich über das Gatedielektrikum 44 hinausragt und zu einem Teil außerhalb des Grabens 410 an der Oberfläche der Isolationsschicht 49 angeordnet ist. Auf diese Weise sind an den gegenüberliegenden Flanken des Grabens 410 je ein Feldeffekttransistor als Speicherzelle angeordnet.

Das Gatedielektrikum 44 enthält jeweils eine ferroelektrische Schicht, so daß die Feldeffekttransistoren von der Polarisation der ferroelektrischen Schicht abhängige, unterschiedliche positive Schwellenspannungen aufweisen. Die gegenüberliegenden Gatelektroden 45 und die gegenüberliegenden Drain-Gebiete 43 sind durch einen Isolationsbereich 46 voneinander isoliert. Als Isolationsbereich 46 ist z. b. eine BOX-Isolation geeignet. Der Isolationsbereich 46 reicht tiefer in das Substrat 41 hinein als die Drain-Gebiete 43. Über eine Wortleitung 45a sind die Gateelektroden 45 miteinander verbunden.

Der Graben 410 hat eine Ausdehnungin einer Längsrichtung senkrecht zur Zeichenebene (s. auch Fig. 8, die den mit VIII-VIII in Fig. 7 gekennzeichneten Schnitt darstellt). In der erfindungsgemäßen Speicherzellenanordnung sind Feldeffekttransistoren matrixartig in Zeilen und Spalten angeordnet. Dabei ist jeweils auf der Flanke eines Grabens 410 eine Zeile von Feldeffektransistoren angeordnet. Eine zweite Zeile von Feldeffekttransistoren ist jeweils auf der gegenüberliegenden Flanke des gleichen Grabens 410 angeordnet. Parallel dazu verlaufen weitere Gräben im Substrat 41.

Parallel zu den Flanken des Grabens 410 sind die jeweils entlang einer Flanke des Grabens 410 angeordneten Source-Gebiete 42 über Bitleitungen 42a miteinander verbunden. Die Gateelektroden 45 der jeweils in einer Spalte angeordneten Feldeffekttransistoren sind über die Wortleitungen 45a miteinander verbunden. Der Verlauf der Wortleitungen 45a ist in Fig. 8 mit gestrichelten Linien angedeutet.

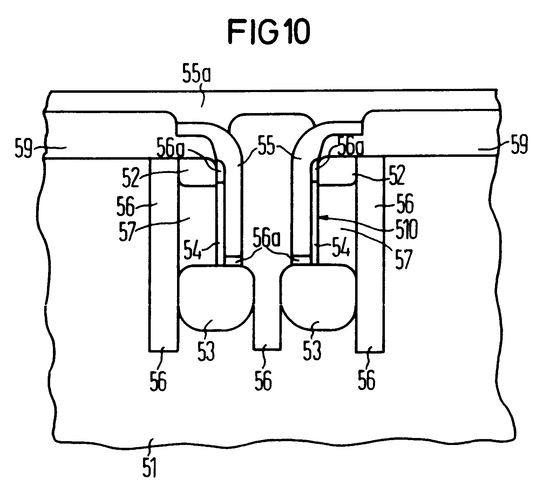

Fig. 9 stellt ein Ersatzschaltbild für ein Speicherzellenpaar dar, wie es anhand von Fig. 7 erläutert wurde.

In einem Substrat 51, das z. B. aus p-dotiertem, einkristallinem Silizium besteht, sind matrixartig in Zeilen und Spalten Feldeffekttransistoren als Speicherzellen angeordnet (s. Fig. 10). Dabei sind jeweils zwei Zeilen von Feldeffekttransistoren an gegenüberliegenden Flanken eines Grabens 510 angeordnet (s. Fig. 10). Der Graben 510 weist eine Ausdehnung senkrecht zur Zeichenebene auf.

Für jeden Feldeffekttransistor ist an der Flanke des Grabens 510 ein Gatedielektrikum 54 angeordnet. Das Gatedielektrikum 54 enthält eine ferroelektrische Schicht. In dem Substrat 51 ist an der Flanke des Grabens 510 im oberen Bereich des Grabens 510 ein Source-Gebiet 52 so angeordnet, daß es sowohl an die Flanke des Grabens 510 als auch an die Oberfläche des Substrats 51 angrenzt. Das source-Gebiet 52 ist z. B. n⁺-dotiert. Auf der der Flanke des Grabens 510 abgewandten Seite des Source-Gebietes 52 ist jeweils ein Isolationsbereich 56 im Substrat 510 so angeordnet, daß der Abstand zwischen der Flanke des Grabens 510 und dem Isolationsbereich 56 im Bereich des Source-Gebietes 52 von dem Source-Gebiet 52 ausgefüllt ist. Senkrecht zur Oberfläche des Substrats 51 ist der Isolationsbereich 56 soweit in das Substrat 51 ausgedehnt, daß ein dotierter Bereich 57, der von demselben Leitfähigkeitstyp wie das Substrat, d. h. z. B. p-dotiert ist, durch den Isolationsbereich 56, das Source-Gebiet 52, das Gatedielektrikum 54 und ein am Boden des Grabens 510 angeordnetes, dem Gatedielektrikum 54 benachbartes Drain-Gebiet 53 vollständig umrandet ist. Das Drain-Gebiet 53 ist z. B. n⁺-dotiert.

Auf der dem dotierten Gebiet 57 abgewandten Seite des Gatedielektrikums 54 ist eine Gatelektrode 55 angeordnet. Die Gateelektrode 55 besteht z. B. aus polykristallinem Silizium und ist so auf dem Gatedielektrikum 54 angeordnet, daß sie sowohl von dem Source-Gebiet 52 als auch von dem Drain-Gebiet 53 durch Isolationen 56a isoliert ist, und daß sie das Gatedielektrikum 54 seitlich überragt und mindestens zu einem Teil auf einer an der Oberfläche des Substrats 51 angeordneten Isolationsschicht 59 angeordnet ist. Die beiden Gateelektroden 55 werden durch einen weiteren Isolationsbereich 56, der den Graben 510 vollständig ausfüllt, voneinander isoliert. Dieser weitere Isolationsbereich 56 isoliert ebenfalls die Draingebiete 53 voneinander. Die Drain-Gebiete 53 füllen den Raum zwischen den beiden, ihnen benachbarten Isolationsbereichen 56 vollständig aus.

Die gegenüberliegenden Gateelektroden 55 sind über eine Wortleitung 55a miteinander verbunden. Die Wortleitung 55a besteht z. B. aus polykristallinem Silizium.

Über das dotierte Gebiet 57 wird an die Feldeffekttransistoren einer Zeile unabhängig von den Feldeffekttransistoren entlang der übrigen Zeilen eine indiviuduelle Substratspannung angelegt. Das dotierte Gebiet 57 ist von dem allgemeinen Substrat 51 vollständig isoliert.

Die anhand von Fig. 7 und Fig. 10 erläuterten Ausführungsformen der Erfindung haben den Vorteil, daß sie einen sehr geringen Flächenbedarf pro Speicherzelle haben.

In den aufgeführten Ausführungsbeispielen sind die Feldeffekttransistoren n-Kanal-Transistoren. Die Erfindung ist entsprechend auch mit p-Kanal-Transistoren ausführbar.

## Patentansprüche

1. Speicherzellenanordnung mit folgenden Merkmalen:
in einem Halbleitersubstrat (1, 11, 21, 31, 41, 51) ist als Speicherzelle mindestens ein Feldeffekttransistor mit einem Source-Gebiet (2, 12, 22, 32, 42, 52), einem DrainGebiet (13, 23, 33, 43, 53), einem Gatedielektrikum (14, 24, 34, 44, 54) und einer Gateelektrode (5, 15, 25, 35, 45, 55) vorgesehen, wobei das Halbleitersubstrat (1, 11, 21, 31, 41, 51) von einem ersten Leitfähigkeitstyp dotiert ist und das Source-Gebiet (2, 12, 22, 32, 42, 52) und das Drain-Gebiet (3, 13, 23, 33, 43, 53) von einem zweiten, zum ersten Leitfäigkeitstyp entgegengesetzten Leitfähigkeitstyp dotiert sind
dadurch gekennzeichnet, daß
das Gatedielektrikum (4, 14, 24, 34, 44, 54) mindestens eine ferroelektrische Schicht (142) enthält.

2. Speicherzellenanordnung nach Anspruch 1 mit folgenden Merkmalen:
a) in dem Halbleitersubstrat (1, 11, 21, 31, 41, 51) sind als Speicherzellen-Feldeffekttransistoren jeweils mit einem eine ferroelektrische Schicht enthaltenden Gatedielektrikum (4, 14, 24, 34, 44, 54), einer Gateelektrode (5, 15, 25, 35, 45, 55), einem Source-Gebiet (2, 12, 22, 32, 42, 52) und einem Drain-Gebiet (3, 13, 23, 33, 43, 53) matrixartig in Zeilen und Spalten angeordnet,
b) die Feldeffektransistoren weisen abhängig von der Polarisation der ferroelektrischen Schicht (142) zwei unterschiedliche Schwellenspannungen auf, die dasselbe Vorzeichen haben und die zwei verschiedenen logischen Zuständen zugeordnet sind,
c) die Gateelektroden (5, 15, 25, 35, 45, 55) jeder Spalte sind jeweils mit einer Wortleitung (5a, 25a, 35a, 45a, 55a), die Source-Gebiete (2, 12, 22, 32, 42, 52) jeder Zeile sind jeweils mit einer Bitleitung (2a, 42a) und die Drain-Gebiete (3, 13, 23, 33, 43, 53) jeder Zeile sind jeweils mit einer Drainleitung (3a) verbunden.

3. Speicherzellenanordnung nach Anspruch 1 oder 2, bei der das Halbleitersubstrat (1, 11, 21, 31, 41, 51) ein Siliziumeinristall ist.

4. Speicherzellenanordnung nach Anspruch 3, bei der das Gatedielektrikum (14) aus einer ersten SiO₂-Schicht (141), der ferroelektrischen Schicht (142) und einer zweiten SiO₂-Schicht (143) besteht.

5. Speicherzellenanordnung nach Anspruch 4, bei der das Verhältnis der relativen Dielektrizitätskonstanten des Materials der ferroelektrischen Schicht und des SiO₂ im wesentlichen gleich dem Verhältnis der Dicken der ferroelektischen Schicht (142) und der ersten SiO₂-Schicht (141) ist.

6. Speicherzellenanordnung nach einem der Ansprüche 1 bis 5 mit folgenden Merkmalen:
a) benachbarte Feldeffekttransistoren, deren Gateelektroden (25, 35) über eine Wortleitung (25a, 35a) miteinander verbunden sind, sind durch Isolationsbereiche (26, 36) im Substrat (21, 31) voneinander isoliert,
b) unterhalb jedes Feldeffektransistors ist im Substrat (21, 31) eine erste dotierte Schicht (27, 37), die vom ersten Leitfähigkeitstyp dotiert ist, und eine zweite dotierte Schicht (28, 38), die vom zweiten Leitfähigkeitstyp dotiert ist, vorgesehen,
c) die erste dotierte Schicht (27, 37) und die zweite dotierte Schicht (28, 38) sind von den den jeweiligen Feldeffekttransistor seitlich isolierenden Isolationsbereichen (26, 36) seitlich begrenzt.

7. Speicherzellenanordnung nach Anspruch 6, bei der die Isolationsbereiche (26, 36) als BOX-Isolationen ausgebildet sind.

8. Speicherzellenanordnung nach Anspruch 6 oder 7 mit folgenden Merkmalen:
a) unter der zweiten dotierten Schicht (38) ist im Substrat (31) eine dritte dotierte Schicht (39), die vom ersten Leitfähigkeitstyp dotiert ist, und unter der dritten dotierten Schicht (39) eine vierte dotierte Schicht (40), die vom zweiten Leitfähigkeitstyp dotiert ist, angeordnet,
b) die dritte dotierte Schicht (39) und die vierte dotierte Schicht (40) sind seitlich von den den jeweiligen Feldeffekttransistor seitlich isolierenden Isolationsbereichen (36) begrenzt,
c) die Dotierstoffkonzentration der ersten dotierten Schicht (37), der zweiten dotierten Schicht (38) und der dritten dotierten Schicht (39) sind dabei so hoch, daß die aus der ersten dotierten Schicht (37) und der zweiten dotierten Schicht (38) sowie aus der zweiten dotierten Schicht (38) und der dritten dotierten Schicht (39) gebildeten Zenerdioden Durchbruchsspannungen haben, die mit der für die Umpolarisation der ferroelektrischen Schicht erforderlichen Spannung überschritten werden.

9. Speicherzellenanordnung nach einem der Ansprüche 1 bis 5 mit folgenden Merkmalen:
a) in dem Halbleitersubstrat (41, 51) ist mindestens ein senkrecht zur Oberfläche des Substrats (41, 51) ausgerichteter Graben (410, 510) vorgesehen,
b) in dem Graben (410, 510) sind an gegenüberliegenden, zur Oberfläche des Substrats (41, 51) senkrechten Flanken je einer der Feldeffekttransistoren angeordnet.

10. Speicherzellenanordnung nach Anspruch 9 mit folgenden Merkmalen:
a) das Gatedielektrikum (44, 54) ist jeweils auf der Flanke des Grabens (410, 510) angeordnet,
b) auf dem Gatedielektrikum (44, 54) ist die Cateelektrode (45, 55) so angeordnet, daß sie seitlich über das Gatedielektrikum (44, 54) herausragt und zu einem Teil außerhalb des Grabens (410, 510) an der Oberfläche des Substrats (41, 51) angeordnet ist,
c) die Gateelektroden (45, 55) der beiden, im Graben (410, 510) angeordneten Feldeffekttransistoren sind durch eine Isolationsstruktur (46, 56), die den Graben (410, 510) auffüllt, voneinander isoliert.

11. Speicherzellenanordnung nach Anspruch 10 mit folgenden Merkmalen:
a) das Source-Gebiet (42, 52) ist jeweils im Substrat (41, 51) so angeordnet, daß es sowohl an die Flanke des Grabens (410, 510) als auch an die Oberfläche des Substrats (41, 51) angrenzt,
b) an der Öberfläche des Substrats (41, 51) ist das SourceGebiet (42, 52) durch eine Isolationsschicht (49, 59) von der Gateelektrode (45, 55) isoliert,
c) das Drain-Gebiet (43, 53) ist im Substrat (41, 51) jeweils am Boden des Grabens (410, 510) angeordnet,
d) die Isolationsstruktur (46, 56) reicht mindestens soweit in das Substrat (41, 51) hinein, daß sie die Drain-Gebiete (43, 53) der beiden, im Graben (410, 510) angeordneten Feldeffekttransistoren voneinander isoliert.

12. Speicherzellenanordnung nach Anspruch 11 mit folgenden Merkmalen:
a) auf der der Flanke des Grabens (510) abgewandten Seite des Source-Gebietes (52) ist jeweils ein Isolationsbereich (56) im Substrat (51) so angeordnet, daß der Abstand zwischen der Flanke des Grabens (510) und dem Isolationsbereich (56) im Bereich des Source-Gebietes (52) von dem Source-Gebiet (52) ausgefüllt ist,
b) in zur Oberfläche des Substrats (51) senkrechter Richtung reicht der Isolationsbereich (56) tiefer als das Draingebiet (53) in das Substrat (51) hinein,
c) das Drain-Gebiet (53) füllt den Abstand zwischen der Isolationsstruktur (56) und dem Isolationsbereich (56) auf der Höhe des Drain-Gebietes (53) vollständig aus, so daß zwischen dem Source-Gebiet (52) und dem Drain-Gebiet (53) ein vom ersten Leitfähigkeitstyp dotiertes Gebiet (57) angeordnet ist, das elektrisch vom Substrat (51) isoliert ist.

13. Speicherzellenanordnung nach einem der Ansprüche 9 bis 12, bei der der Graben (410, 510) eine Ausdehnung in einer Längsrichtung parallel zur Oberfläche des Substrat (41, 51) aufweist, so daß an den gegenüberliegenden Flanken des Grabens (410, 510) jeweils eine Vielzahl von Feldeffekttransistoren in der Längsrichtung nebeneinander angeordnet sind.

14. Verfahren zum Auslesen einer ausgewählten Speicherzelle in einer Speicherzellenanordnung, die als Speicherzellen in einem Substrat matrixartig in Zeilen und Spalten angeordnete Feldeffekttransistoren mit einem eine ferroelektrische Schicht enthaltendem Gatedielektrikum, einer Gatelektrode, einem Source-Gebiet und einem Drain-Gebiet enthält, in der die Feldeffekttransistoren abhängig von der Polarisation der ferroelektrischen Schicht unterschiedliche Schwellenspannungen aufweisen, die dasselbe Vorzeichen haben und die zwei verschiedenen logischen Zuständen zugeordnet werden, und in der die Gateelektroden jeder Spalte jeweils mit einer Wortleitung und die Source-Gebiete jeder Zeile jeweils mit einer Bitleitung verbunden sind, mit folgenden Schritten:
a) an die Wortleitung (5a, 25a, 35a, 45a, 55a) der ausgewählten Speicherzelle wird eine Spannung angelegt, die dem Betrag nach zwischen den Schwellenspannungen liegt,
b) über die Bitleitung (2a, 42a) der ausgewählten Speicherzelle wird ein vom eingespeicherten logischen Zustand abhängiges Signal abgegriffen.

15. Verfahren zum Einschreiben einer Information in eine ausgewählte Speicherzelle in einer Speicherzellenanordnung, die als Speicherzellen in einem Substrat matrixartig in Zeilen und Spalten angeordnete Feldeffekttransistoren mit einem eine ferroelektrische Schicht enthaltenden Gateelektrikum, einer Gateelektrode, einem Source-Gebiet und einem Drain-Gebiet enthält, in der die Feldeffekttransistoren abhängig von der Polarisation der ferroelektrischen Schicht zwei unterschiedliche Schwellenspannung aufweisen, die dasselbe Vorzeichen haben und die zwei verschiedenen logischen Zuständen zugeordnet werden,
und in der die Gateelektroden jeder Spalte jeweils mit einer Wortleitung und die Source-Gebiete jeder Zeile jeweils mit einer Bitleitung und die Drain-Gebiete jeder Zeile jeweils mit einer Drainleitung verbunden sind, mit folgenden Schritten:
a) zwischen das Substrat (1, 11, 21, 31, 41, 51) und die Wortleitung (5a, 25a, 35a, 45a, 55a) der ausgewählten Speicherzelle wird ein elektrisches Polarisationsfeld angelegt, dessen Betrag größer ist als die Sättigungsfeldstärke der ferroelektrischen Schicht und dessen Richtung von der logischen Information abhängt,
b) zwischen dem Substrat (1, 11, 21, 31, 41, 51) und den Wortleitungen (5a, 25a, 35a, 45a, 55a) der übrigen Speicherzellen liegt eine geringere Feldstärke als die Polarisationsfeldstärke an.

16. Verfahren nach Anspruch 15 mit folgenden Schritten:
a) an die Wortleitung (5a, 25a, 35a, 45a, 55a) der ausgewählten Speicherzelle wird eine positive Spannung von Betrag der Polarisationsfeldstärke angelegt,
b) das Substrat (1, 11, 41) sowie Source-Gebiet (2, 12, 42) und Drain-Gebiet (3, 13, 43) der ausgewählten Speicherzelle sind auf Nullpotential gelegt,
c) die Source-Gebiete (1, 11, 41) und Drain-Gebiete (3, 13, 43) der Speicherzellen, die an derselben Wortleitung (5a, 45a) wie die ausgewählte Speicherzelle liegen, werden mit einer positiven Spannung verbunden, so daß über die ferroelektrische Schicht eine geringere Feldstärke als die zur Umpolarisation nötige Sättigungsfeldstärke auftritt.

17. Verfahren nach Anspruch 15 mit folgenden Schritten:
a) an die Wortleitung (25a, 35a, 55a) der ausgewählten Speicherzelle wird eine positive Spannung vom Betrag der Polarisationsfeldstärke angelegt,
b) das Substrat (21, 31, 51) sowie Source-Gebiet (22, 32, 52) und Drain-Gebiet (23, 33, 53) der ausgewählten Speicherzelle sind auf Nullpotential gelegt,
c) die über die ferroelektrische Schicht der an derselben Wortleitung liegenden, nicht ausgewählten Speicherzellen auftretende Feldstärke wird durch Anlegen einer positiven Spannung an eine im Substrat (21, 31, 51) vorgesehene, dotierte Schicht (27, 37, 57), die von den übrigen, an derselben Wortleitung (25a, 35a, 55a), liegenden Speicherzellen isoliert ist, auf einen Wert unter der zur Umpolarisation erforderlichen Sättigungsfeldstärke eingestellt.

18. Verfahren nach Anspruch 17, bei dem die positve Spannung an die dotierte Schicht (37) über zwei gegenpolig in Reihe geschaltete, im Substrat (31) integrierte Zenerdioden angelegt wird.

19. Verfahren mit Anspruch 15 mit folgenden Schritten:
a) an die Bitleitung (2a, 42a) und die Drainleitung (3a) der ausgewählten Speicherzelle wird eine positive Spannung vom Betrag der Polarisationsfeldstärke angelegt,
b) die Wortleitung (5a, 25a, 35a, 45a, 55a) der ausgewählten Speicherzelle wird auf Nullpotential gelegt,
c) an die übrigen Wortleitungen (5a, 25a, 35a, 45a, 55a) wird eine positive Spannung angelegt, so daß in den nichtausgewählten Speicherzellen über der ferroelektrischen Schicht eine geringere Feldstärke als die zur Umpolarisation notwendige Sättigungsstärke auftritt.

20. Verfahren mit Anspruch 19 mit folgenden Schritten:
a) an eine von den übrigen Speicherzellen an derselben Wortleitung (25a, 35a, 55a) isolierte, unter der ferroelektrischen Schicht im Substrat (21, 31, 51) angeordnete dotierte Schicht (27, 37, 57) wird in der ausgewählten Speicherzelle eine positive Spannung vom Betrag der Polarisationsspannung angelegt,
b) an die Wortleitungen (25a, 35a, 55a) in den an derselben Bitleitung liegenden Speicherzellen wird eine positive Spannung angelegt, so daß in den nichtausgewählten Speicherzellen über der ferroelektrischen Schicht eine geringere Feldstärke als die zur Umpolarisation notwendige Sättigungsfeldstärke auftritt.

## Claims

1. Memory cell arrangement having the following features:
in a semiconductor substrate (1, 11, 21, 31, 41, 51), at least one field-effect transistor having a source region (2, 12, 22, 32, 42, 52), a drain region (13, 23, 33, 43, 53), a gate dielectric (14, 24, 34, 44, 54) and a gate electrode (5, 15, 25, 35, 45, 55) is provided as memory cell, the semiconductor substrate (1, 11, 21, 31, 41, 51) being doped with a first type of conductivity and the source region (2, 12, 22, 32, 42, 52) and the drain region (3, 13, 23, 33, 43, 53) being doped with a second type of conductivity which is opposite to the first type of conductivity, characterized in that the gate dielectric (4, 14, 24, 34, 44, 54) contains at least one ferroelectric layer (142).

2. Memory cell arrangement according to Claim 1, having the following features:
a) in the semiconductor substrate (1, 11, 21, 31, 41, 51), memory cell field-effect transistors, in each case with a gate dielectric (4, 14, 24, 34, 44, 54) containing a ferroelectric layer, a gate electrode (5, 15, 25, 35, 45, 55), a source region (2, 12, 22, 32, 42, 52) and a drain region (3, 13, 23, 33, 43, 53) are arranged matrix-like in rows and columns,
b) the field-effect transistors exhibit, in dependence on the polarization of the ferroelectric layer (142), two different threshold voltages which have the same sign and which are allocated to two different logic states,
c) the gate electrodes (5, 15, 25, 35, 45, 55) of each column are in each case connected to a word line (5a, 25a, 35a, 45a, 55a), the source regions (2, 12, 22, 32, 42, 52) of each row are in each case connected to a bit line (2a, 42a) and the drain regions (3, 13, 23, 33, 43, 53) of each row are in each case connected to a drain line (3a).

3. Memory cell arrangement according to Claim 1 or 2, in which the semiconductor substrate (1, 11, 21, 31, 41, 51) is a silicon monocrystal.

4. Memory cell arrangement according to Claim 3, in which the gate dielectric (14) consists of a first SiO₂ layer (141), the ferroelectric layer (142) and a second SiO₂ layer (143).

5. Memory cell arrangement according to Claim 4, in which the ratio of the relative dielectric constants of the material of the ferroelectric layer and of the SiO₂ is essentially equal to the ratio between the thicknesses of the ferroelectric layer (142) and the first SiO₂ layer (141).

6. Memory cell arrangement according to one of Claims 1 to 5, having the following features:
a) adjacent field-effect transistors, the gate electrodes (25, 35) of which are connected to one another via a word line (25a, 35a), are insulated from one another by insulation areas (26, 36) in the substrate (21, 31),
b) below each field-effect transistor, a first doped layer (27, 37), which is doped with the first type of conductivity, and a second doped layer (28, 38) which is doped with the second type of conductivity, is provided in the substrate (21, 31),
c) the first doped layer (27, 37) and the second doped layer (28, 38) are laterally bounded by the insulation areas (26, 36) laterally insulating the respective field-effect transistor.

7. Memory cell arrangement according to Claim 6, in which the insulation areas (26, 36) are constructed as BOX-type insulations.

8. Memory cell arrangement according to Claim 6 or 7, having the following features:
a) a third doped layer (39), which is doped with the first type of conductivity, is arranged below the second doped layer (38) in the substrate (31) and a fourth doped layer (40), which is doped with the second type of conductivity, is arranged below the third doped layer (39),
b) the third doped layer (39) and the fourth doped layer (40) are laterally bounded by the insulation areas (36) laterally insulating the respective field-effect transistor,
c) the dopant concentration of the first doped layer (37), of the second doped layer (38) and of the third doped layer (39) in this arrangement are of such a magnitude that the Zener diodes formed from the first doped layer (37) and the second doped layer (38) and from the second doped layer (38) and the third doped layer (39) have breakdown voltages which are exceeded by the voltage required for the polarization of the ferroelectric layer.

9. Memory cell arrangement according to one of Claims 1 to 5, having the following features:
a) at least one trench (410, 510) aligned perpendicularly to the surface of the substrate (41, 51) is provided in the semiconductor substrate (41, 51),
b) one of the field effect transistors each is arranged on opposite sides perpendicularly to the surface of the substrate (41, 51) in the trench (410, 510).

10. Memory cell arrangement according to Claim 9, having the following features:
a) the gate dielectric (44, 54) is in each case arranged on the side of the trench (410, 510),
b) the gate electrode (45, 55) is arranged on the gate dielectric (44, 54) in such a manner that it laterally protrudes over the gate dielectric (44, 54) and is partially arranged outside the trench (410, 510) on the surface of the substrate (41, 51),
c) the gate electrodes (45, 55) of the two field-effect transistors arranged in the trench (410, 510) are insulated from one another by means of an insulating structure (46, 56) which fills up the trench (410, 510).

11. Memory cell arrangement according to Claim 10, having the following features:
a) the source region (42, 52) is in each case arranged in the substrate (41, 51) in such a manner that it adjoins both the side of the trench (410, 510) and the surface of the substrate (41, 51),
b) on the surface of the substrate (41, 51), the source region (42, 52) is insulated from the gate electrode (45, 55) by means of an insulation layer (49, 59),
c) the drain region (43, 53) is in each case arranged at the bottom of the trench (410, 510) in the substrate (41, 51),
d) the insulation structure (46, 56) extends into the substrate (41, 51) at least by such an amount that it insulates the drain regions (43, 53) of the two field-effect transistors arranged in the trench (410, 510) from one another.

12. Memory cell arrangement according to Claim 11, having the following features:
a) on the side of the source region (52) facing away from the side of the trench (510), an insulation area (56) is in each case arranged in the substrate (51) in such a manner that the distance between the side of the trench (510) and the insulation area (56) is filled by the source region (52) in the area of the source region (52),
b) in the direction perpendicular to the surface of the substrate (51), the insulation area (56) penetrates deeper into the substrate (51) than the drain region (53),
c) the drain region (53) completely fills the distance between the insulation structure (56) and the insulation area (56) at the level of the drain region (53) so that a region (57) doped with the first type of conductivity, which is electrically insulated from the substrate (51), is arranged between the source region (52) and the drain region (53).

13. Memory cell arrangement according to one of Claims 9 to 12, in which the trench (410, 510) exhibits an extent in a longitudinal direction parallel to the surface of the substrate (41, 51) so that in each case a plurality of field-effect transistors are arranged adjacent to one another in the longitudinal direction on the opposite sides of the trench (410, 510).

14. Method for reading out a selected memory cell in a memory cell arrangement which contains field-effect transistors with a gate dielectric containing a ferroelectric layer, a gate electrode, a source region and a drain region, arranged matrix-like in rows and columns as memory cells in a substrate, in which arrangement the field-effect transistors exhibit different threshold voltages in dependence of the polarization of the ferroelectric layer which have the same sign and are allocated to two different logic states and in which the gate electrodes of each column are in each case connected to a word line and the source regions of each row are in each case connected to a bit line, comprising the following steps:
a) a voltage, the amount of which is between the threshold voltages, is applied to the word line (5a, 25a, 35a, 45a, 55a) of the selected memory cell,
b) a signal depending on the stored logic state is picked up via the bit line (2a, 42a) of the selected memory cell.

15. Method for writing an information item into a selected memory cell in a memory cell arrangement which contains field-effect transistors with a gate dielectric containing a ferroelectric layer, a gate electrode, a source region and a drain region, arranged matrix-like in rows and columns as memory cells in a substrate, in which arrangement the field-effect transistors exhibit two different threshold voltages in dependence of the polarization of the ferroelectric layer, which have the same sign and which are allocated to two different logic states, and in which the gate electrodes of each column are in each case connected to a word line and the source regions of each row are in each case connected to a bit line, and the drain regions of each row are in each case connected to a drain line, comprising the following steps:
a) an electric polarization field, the amount of which is greater than the saturation field strength of the ferroelectric layer and the direction of which depends on the logical information is applied between the substrate (1, 11, 21, 31, 41, 51) and the word line (5a, 25a, 35a, 45a, 55a) of the selected memory cell,
b) between the substrate (1, 11, 21, 31, 41, 51) and the word lines (5a, 25a, 35a, 45a, 55a) of the remaining memory cells, a lower field strength than the polarization field strength is present.

16. Method according to Claim 15, comprising the following steps:
a) a positive voltage of the amount of the polarization field strength is applied to the word line (5a, 25a, 35a, 45a, 55a) of the selected memory cell,
b) the substrate (1, 11, 41) and source region (2, 12, 42) and drain region (3, 13, 43) of the selected memory cell are connected to zero potential,
c) the source regions (1, 11, 41) and drain regions (3, 13, 43) of the memory cells, which are connected to the same word line (5a, 45a) as the selected memory cell, are connected to a positive voltage so that a lower field strength than the saturation field strength necessary for repolarisation occurs across the ferroelectric layer.

17. Method according to Claim 15, comprising the following steps:
a) a positive voltage of the amount of the polarization field strength is applied to the word line (25a, 35a, 55a) of the selected memory cell,
b) the substrate (21, 31, 51) and source region (22, 32, 52) and drain region (23, 33, 53) of the selected memory cell are connected to zero potential,
c) the field strength occurring across the ferroelectric layer of the unselected memory cells connected to the same word line is set to a value below the saturation field strength required for repolarization by applying a positive voltage to a doped layer (27, 37, 57) provided in the substrate (21, 31, 51), which is insulated from the remaining memory cells located on the same word line (25a, 35a, 55a).

18. Method according to Claim 17, in which the positive voltage is applied to the doped layer (37) via two Zener diodes integrated in the substrate (31) connected in series with opposite polarity.

19. Method according to Claim 15, comprising the following steps:
a) a positive voltage of the amount of the polarization field strength is applied to the bit line (2a, 42a) and the drain line (3a) of the selected memory cell,
b) the word line (5a, 25a, 35a, 45a, 55a) of the selected memory cell is connected to zero potential,
c) a positive voltage is applied to the remaining word lines (5a, 25a, 35a, 45a, 55a) so that a lower field strength than the saturation field strength necessary for repolarization occurs across the ferroelectric layer in the unselected memory cells.

20. Method according to Claim 19, comprising the following steps:
a) a positive voltage of the amount of the polarization voltage is applied in the selected memory cell to a doped layer (27, 37, 57) which is arranged below the ferroelectric layer in a substrate (21, 31, 51) and is insulated from the remaining memory cells on the same word line (25a, 35a, 55a),
b) a positive voltage is applied to the word lines (25a, 35a, 55a) in the memory cells connected to the same bit line so that a lower field strength than the saturation field strength necessary for repolarization occurs across the ferroelectric layer in the unselected memory cells.

## Revendications

1. Dispositif de cellules de mémoire présentant les caractéristiques suivantes :
dans un substrat semiconducteur (1,11,21,31,41,51) sont prévus, en tant que cellule de mémoire, au moins un transistor à effet de champ possédant une région de source (2,12,22,32,42,52), une région de drain (13,23,33,43,53), un diélectrique de grille (14,24,34,44,54) et une électrode de grille (5,15,25,35,45,55), le substrat semiconducteur 1,11,21, 31,41,51) étant dopé avec un premier type de conductivité tandis que la région de source (2,12,22,32,42,52) et la région de drain (3,13,23,33,43,53) sont dopées par un second type de conductivité opposé au premier type de conductivité,
caractérisé par le fait
que le diélectrique de grille (4,14,24,34,44,54) contient au moins une couche ferroélectrique (142).

2. Dispositif de cellules de mémoire suivant la revendication 1, présentant les caractéristiques suivantes :
a) dans le substrat semiconducteur (1,11,21,31,41,51), en tant que cellules de mémoire sont disposés, suivant une forme matricielle selon des lignes et des colonnes, des transistors à effet de champ comportant chacun un diélectrique de grille (4,14,24,34,44,54) contenant une couche ferroélectrique, une électrode de grille (5,15,25, 35,45,55), une région de source (2,12,22,32,42,52) et une région dedrain (3,13,23,33,43,53),
b) les transistors à effet de champ possèdent, en fonction de la polarisation de la couche ferroélectrique (142), deux tensions de seuil différentes, qui possèdent les mêmes signes et qui sont associées à deux états logiques différents,
c) des électrodes de grille (5,15,25,35,45,55) de chaque colonne sont reliées respectivement à une ligne de transmission de mots (5a,25a,35a,45a,55a), les régions de source (2,12,22,32,42,52) de chaque ligne sont reliées respectivement à une ligne de transmission de bits (2a,42a) et les régions de drain (3,13,23,33,43,53) de chaque ligne sont reliées respectivement à une ligne de drain (3a).

3. Dispositif de cellules de mémoire suivant la revendication 1 ou 2, dans lequel le substrat semiconducteur (1,11,21,31,41,51) est un monocristal de silicium.

4. Dispositif de cellules de mémoire suivant la revendication 3, dans lequel le diélectrique de grille (14) est constitué par une première couche de SiO₂ (141), par la couche ferroélectrique (142) et par une seconde couche de SiO₂ (143).

5. Dispositif de cellules de mémoire suivant la revendication 4, dans lequel le rapport de la constante diélectrique relative du matériau ou de la couche ferroélectrique et du SiO₂ est essentiellement égal au rapport des épaisseurs de la couche ferroélectrique (142) de la première couche de SiO₂ (141).

6. Dispositif de cellules de mémoire suivant l'une des revendications 1 à 5, présentant les caracté-ristiques suivantes :
a) des transistors à effet de champ voisins, dont les électrodes de grille (25,35) sont reliées entre elles par l'intermédiaire d'une ligne de transmission de mots (25a,35a), sont isolées l'une de l'autre par des régions isolantes (26,36) dans le substrat (21,31),
b) au-dessous de chaque transistor à effet de champ sont prévues, dans le substrat (21,31), une première couche dopée (27,37), qui est dopée avec le premier type de conductivité, et une seconde couche dopée (28,38), qui est dopée avec le second type de conductivité,
c) la première couche dopée (27,37) et la seconde couche dopée (28,38) sont limitées latéralement par les régions isolantes (26,36) qui isolent latéralement le transistor à effet de champ respectif.

7. Dispositif de cellules de mémoire suivant la revendication 6, dans lequel les régions isolantes (26,36) sont réalisées sous la forme d'isolations BOX.

8. Dispositif de cellules de mémoire suivant la revendication 6 ou 7 présentant les caractéristiques suivantes :
a) au-dessous de la seconde couche dopée (38) est disposée, dans le substrat (31), une troisième couche dopée (39), qui est dopée avec le premier type de conductivité, et au-dessus de la troisième couche (39) est disposée une quatrième couche dopée (40), qui est dopée avec le second type de conductivité,
b) la troisième couche dopée (39) et la quatrième couche dopée (40) sont limitées latéralement par les régions isolantes (36), qui isolent latéralement le transistor à effet de champ respectif,
c) la concentration en substances dopantes de la première couche dopée (37), de la seconde couche dopée (38) et de la troisième couche dopée (39) sont si élevées que les diodes Zener, qui sont formées par la première couche dopée (37) et la seconde couche dopée (38) ainsi que par la seconde couche dopée (38) et la troisième couche dopée (39), possèdent des tensions de claquage qui sont dépassées par la tension nécessaire pour l'inversion de polarisation de la couche ferroélectrique.

9. Dispositif de cellules de mémoire suivant l'une des revendications 1 à 5, présentant les caractéristiques suivantes :
a) dans le substrat semiconducteur (41,51) est prévu au moins un sillon (410,510), qui est orienté perpendiculairement à la surface du substrat (41,51),
b) dans le sillon (410,510), les transistors à effet de champ sont respectivement disposés sur des flancs opposés, perpendiculaires à la surface du substrat (41,51).

10. Dispositif de cellules de mémoire suivant la revendication 9, présentant les caractéristiques suivantes :
a) le diélectrique de grille (44,54) est disposé respectivement sur le flanc du sillon (410,510),
b) l'électrode de grille (47,55) est disposée sur le diélectrique de grille (44,54) de telle sorte qu'elle fait saillie latéralement au-delà du diélectrique de grille (44,54) et est disposée en partie à l'extérieur du sillon (410,510) sur la surface du substrat (41,51),
c) les électrodes de grille (45,55) des deux transistors à effet de champ disposés dans le sillon (410,510) sont isolées l'une de l'autre par une structure isolante (46,56), qui remplit les deux sillons (410,510).

11. Dispositif de cellules de mémoire suivant la revendication 10, présentant les caractéristiques suivantes :
a) la région de source (42,52) est disposée respectivement dans le substrat (41,51) de telle sorte qu'elle jouxte aussi bien le flanc du sillon (410,510) que le surface du substrat (41,51),
b) sur la surface du substrat (41, 51), la région de source (42,52) est isolée de l'électrode de grille (45,55) par une couche isolante (49,59),
c) la région de drain (43,53) est disposée dans le substrat (41,51) respectivement dans le fond du sillon (410,510),
d) la structure isolante (46,56) pénètre dans le substrat (41,51), au moins au point d'isoler l'une de l'autre les régions de drain (43,53) des deux transistors à effet de champ disposés dans le sillon (410,510).

12. Dispositif de cellules de mémoire suivant la revendication 11, présentant les caractéristiques suivantes :
a) respectivement une région isolante (56) est disposée dans le substrat (51) sur le côté de la région de source (52), tourné à l'opposé du flanc du sillon (510), de telle sorte que la distance entre le flanc du sillon (510) et la région isolante (56) est remplie, au niveau de la région de source (52) par cette région de source (52),
b) dans une direction perpendiculaire à la surface du substrat (51), la région isolante (56) pénètre plus profondément que la région de drain (53) dans le substrat (51),
c) la région de drain (53) remplit complètement l'espace entre la structure isolante (56) et la région isolante (56) à la hauteur de la région de drain (53) de sorte qu'entre la région de source (52) et la région de drain (53) est disposée une région (57) dopée avec le premier type de conductivité et qui est isolée électriquement du substrat (51).

13. Dispositif de cellules de mémoire suivant l'une des revendications 9 à 12, dans lequel le sillon (410,510) possède une étendue dans une direction longitudinale parallèle à la surface du substrat (41,51) de telle sorte que respectivement une multiplicité de transistors à effet de champ sont disposés côte-à-côte dans la direction longitudinale, sur des flancs opposés du sillon (410,510).

14. Procédé pour lire une cellule de mémoire sélectionnée dans un dispositif de cellules de mémoire qui contient, en tant que cellules de mémoire, des transistors à effet de champ agencés selon une disposition matricielle suivant des lignes et des colonnes dans le substrat et comportant un diélectrique de grille contenant une couche ferroélectrique, une électrode de grille, une région de source et une région de drain et dans lequel les transistors à effet de champ possèdent, en fonction de la polarisation de la couche ferroélectrique, des tensions de seuil différentes, qui possèdent le même signe et qui sont associées à deux états logiques différents, dans lequel les électrodes de grille de chaque colonne sont reliées respectivement à une ligne de transmission de mots et les régions de source de chaque ligne sont reliées respectivement à une ligne de transmission de bits, à l'aide des étapes opératoires suivantes :
a) on applique à la ligne de transmission de mots (5a,25a, 35a,45a,55a) de la cellule de mémoire sélectionnée, une tension dont la valeur absolue est située entre les tensions de seuil,
b) on prélève un signal qui dépend de l'état logique mémorisé par l'intermédiaire de la ligne de transmission de bits (2a,42a), à partir de la cellule de mémoire sélectionnée.

15. Procédé pour enregistrer une information dans une cellule de mémoire sélectionnée dans un dispositif de cellules de mémoire qui contient, en tant que cellules de mémoire, des transistors à effet de champ agencés selon une disposition matricielle suivant des lignes et des colonnes dans le substrat et comportant un diélectrique de grille contenant une couche ferroélectrique, une électrode de grille, une région de source et une région de drain, et dans lequel les transistors à effet de champ possèdent, en fonction de la polarisation de la couche ferroélectrique, des tensions de seuil différentes, qui ont le même signe et sont associées à deux états logiques différents, et dans lequel les électrodes de grille de chaque colonne sont reliées respectivement à une ligne de transmission de mots et les régions de source de chaque ligne sont reliées respectivement à une ligne de transmission de bits, à l'aide des étapes opératoires suivantes :
a) entre le substrat (1,11,21,31,41,51) et la ligne de transmission de mots (5a,25a,35a,45a,55a) de la cellule de mémoire sélectionnée on applique un champ électrique de polarisation, dont la valeur absolue est supérieure à l'intensité du champ de saturation de la couche ferroélectrique et dont la direction dépend de l'information logique,
b) une intensité de champ inférieure à l'intensité de champ de polarisation est présente entre le substrat (1,11,21,31,41,51) et les ligne de transmission de mots (5a,25a,35a,45a,55a) des cellules de mémoire.

16. Procédé suivant la revendication 15, comportant les étapes suivantes :
a) on applique une tension positive possédant une valeur absolue égale à l'intensité de champ de polarisation à la ligne de transmission de mots (5a,25a,35a,45a,55a) de la cellule de mémoire sélectionnée,
b) on place au potentiel nul le substrat (1,11,41) ainsi que la région de source (2,12,42) et la région de drain (3,13,43) de la cellule de mémoire sélectionnée,
c) on applique une tension positive aux régions de source (1,11,41) et aux régions de drain (3,13,43) des cellules de mémoire, qui sont raccordées à la même ligne de transmission de mots (5a,45a) que la cellule de mémoire sélectionnée, de sorte qu'au-dessus de la couche électrique, il apparaît une intensité de champ inférieure à l'intensité de champ de saturation nécessaire pour l'inversion de la polarisation.

17. Procédé suivant la revendication 15, comprenant les étapes suivantes :
a) on applique une tension positive ayant la valeur absolue de l'intensité de champ de polarisation à la ligne de transmission de mots (25a,35a,55a) de la cellule de mémoire sélectionnée,
b) on place au potentiel nul le substrat (21,31,51) ainsi que la région de source (22,32,52) et la région de drain (23,33,53) de la cellule de mémoire sélectionnée,
c) on règle à une valeur inférieure à la tension de saturation nécessaire pour l'inversion de polarisation, l'intensité de champ apparue au-dessus de la couche ferroélectrique des cellules de mémoire non sélectionnées, raccordées à la même ligne de transmission de mots, par application d'une tension positive à une couche dopée (27,37,57), qui est prévue dans le substrat (21,31,51) et qui est isolée par rapport aux autres cellules de mémoire qui sont situées dans la même ligne de transmission de mots (25a,35a,55a).

18. Procédé suivant la revendication 17, selon lequel une tension positive est appliquée à la couche dopée (37) par l'intermédiaire de deux diodes Zener branchées en série avec des polarisations opposées et intégrées dans le substrat (31).

19. Procédé suivant la revendication 15, comprenant les étapes suivantes :
a) on applique une tension positive possédant la valeur absolue de l'intensité de champ de polarisation à la ligne de transmission de bits (2a,42a) et à la ligne de drain (30a) de la cellule de mémoire sélectionnée,
b) on place au potentiel nul la ligne de transmission de mots (5a,25a,35a,45a,55a) de la cellule de mémoire sélectionnée,
c) on applique une tension positive aux autres lignes de transmission de mots (5a,25a,35a,45a,55a) de sorte qu'une intensité de champ inférieure à l'intensité de saturation nécessaire pour l'inversion de la polarisation apparaît au-dessus de la couche ferroélectrique dans les cellules de mémoire non sélectionnées.

20. Procédé suivant la revendication 19, comportant les étapes suivantes :
a) dans la cellule de mémoire sélectionnée, on applique une tension positive possédant la valeur absolue de la tension de polarisation à une couche (27,37,57) isolée des autres cellules de mémoire dans la même ligne de transmission de mots (25a,35a,55a) et disposée au-dessous de la couche ferroélectrique dans le substrat (21,31,41, 51),
b) on applique une tension positive aux lignes de transmission de mots (25a,35a,55a) dans les cellules de mémoire raccordées à la même ligne de transmission de bits de sorte que àans les cellules de mémoire non sélectionnées, une intensité de champ inférieure à l'intensité de champ de saturation nécessaire pour l'inversion de la polarisation apparaît au-dessus de la couche ferroélectrique.
